(19) Europäisches Patentamt
European Patent Office
Office européen des brevets

(11) EP 3 136 499 B1

(12) FASCICULE DE BREVET EUROPEEN

(45) Date de publication et mention
de la délivrance du brevet:
23.09.2020 Bulletin 2020/39

(51) Int Cl.:
*H01P 5/08* (2006.01)      *H01P 5/12* (2006.01)

(21) Numéro de dépôt: 16182929.6

(22) Date de dépôt: 05.08.2016

(54) **SYSTÈME DIVISEUR/COMBINEUR POUR ONDE HYPERFÉQUENCE**

AUFTEILUNGS-/KOMBINATIONSSYSTEM FÜR HYPERFREQUENZWELLE

DIVIDER/COMBINER SYSTEM FOR A HYPERFREQUENCY WAVE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.08.2015 FR 1501760**

(43) Date de publication de la demande:
**01.03.2017 Bulletin 2017/09**

(73) Titulaire: **Thales
92400 Courbevoie (FR)**

(72) Inventeurs:
• **DENIS, Stéphane
35340 LA BOUEXIERE (FR)**
• **CHAMPAGNE, Christophe
35370 ETRELLES (FR)**
• **HAMEAU, Solenne
35220 CHATEAUBOURG (FR)**

(74) Mandataire: **Joubert, Cécile et al
Marks & Clerk France
Counseils en Propriete Industrielle
Immeuble "Visium"
22, avenue Aristide Briand
94117 Arcueil Cedex (FR)**

(56) Documents cités:
CN-A- 102 280 681      US-A- 4 680 557
US-A- 5 142 253      US-A- 5 256 988

## Description

## DOMAINE DE L'INVENTION

L'invention concerne le domaine des composants passifs pour onde hyperfréquence, et plus particulièrement des composants diviseur ou combineur de faisceaux. Ces composants permettent de subdiviser un signal en plusieurs voies ou de recombiner des signaux issus de différentes voies sur une seule voie.
L'invention concerne également un amplificateur de puissance radiofréquence et microonde réalisé à partir des composants diviseurs/combineurs, l'amplificateur étant subdivisé en de multiples amplificateurs élémentaires en parallèle. L'invention trouve une utilité dans tous les systèmes qui utilisent des amplificateurs de type tubes à ondes progressives ou TOP tels que les radars embarqués sur des systèmes de forage et des missiles, ou des systèmes embarqués sur des drones ou des satellites. Les amplificateurs à tubes à ondes progressives peuvent avantageusement être remplacés par des amplificateurs à base de diviseurs/combineurs selon l'invention.

## ETAT DE LA TECHNIQUE

Les plus fortes puissances RF sont un domaine réservé aux amplificateurs à tubes à ondes progressives (TOP) et autres magnétrons ou klystrons. Ceux-ci permettent d'atteindre des niveaux de puissance inaccessibles avec de simples amplificateurs à état solide, constitués de transistors.
Pour des niveaux de puissance modérés il existe aussi des TOP compacts dont l'encombrement est similaire à celui des amplificateurs basiques à transistors.
Cependant, avec les progrès obtenus ces dernières années sur les transistors à semi-conducteurs de type GaN et/ou SiC, ces composants permettent de réaliser des amplificateurs à état solide qui gagnent du terrain sur les gammes de puissances couvertes par les TOP, avec de surcroit plusieurs avantages :

- Une fiabilité et une durée de vie supérieures
- Une bande passante plus large
- Un facteur de bruit réduit
- Une linéarité accrue
- Une tension d'alimentation plus conventionnelle

Les amplificateurs à état solide sont réalisés sous forme monolithique ou bien sous forme de composants hybrides, jusqu'à un certain niveau de puissance qui s'étend actuellement jusqu'à une centaine de Watts en bande X. Au-delà, il faut utiliser en parallèle plusieurs amplificateurs élémentaires (monolithiques ou hybrides) pour générer des puissances encore plus grandes et ainsi dépasser le kW.
Pour cela, le signal est subdivisé en plusieurs voies vers les différents amplificateurs élémentaires. Les signaux amplifiés sont ensuite recombinés vers une seule voie. Le plus souvent, le même type de dispositif peut servir de diviseur ou de combineur de puissance. On passe d'un rôle à l'autre en permutant les sources et les charges.

Pour que l'ensemble soit énergétiquement efficace, il convient d'optimiser les pertes d'insertion de ces diviseurs-combineurs. De ce point de vue, les structures à base de guides d'ondes sont les plus performantes. Elles présentent de très faibles pertes d'insertion et supportent des puissances très fortes, notamment sous forme de guide d'onde rectangulaires. Toutefois, ces structures et notamment celles qui utilisent les guides d'ondes rectangulaires sont très encombrantes et présentent des limitations en termes de bandes de fréquences qui sont liées aux limites d'encombrement et aux multiples modes propagés. Par exemple, ces structures ne conviennent pas pour une bande de fréquence couvrant au moins la bande X et pour un encombrement d'un diamètre inférieur à 50mm.

Le document US5142253 décrit une solution avec une combinaison spatiale de puissance sur la base d'un guide d'onde coaxial surdimensionné.

Le terme « surdimensionné » signifie ici que les diamètres de la structure coaxiale sont supérieurs aux dimensions maximales qui assurent au guide un fonctionnement sur le seul mode fondamental ou que les cavités sont exemptes de résonances dans la bande utile. A titre indicatif, un guide cylindrique présente un premier mode de propagation (TE11) situé au-dessus de 10GHz dès que son diamètre dépasse 8.8mm, et une ligne coaxiale d'impédance caractéristique 50 Ohms présente plusieurs modes de propagation (dont TE11) au-dessus de 10GHz dès que son grand diamètre dépasse 13.3mm.
Pour résumer et pour donner un ordre de grandeur, au-dessus de 10GHz, une structure approximativement cylindrique, dont le diamètre interne dépasse 9mm peut poser des problèmes de modes de propagation multiples ou de résonances parasites.
Pour préserver une réalisation simple, cette structure conduit à des diamètres surdimensionnés sur plus des 2/3 de sa longueur, pour des fréquences supérieures à 10 GHz.
Cette solution nécessite d'importants volumes occupés par des absorbants RF qui augmentent nécessairement les pertes. Il n'est pas possible de retirer ces absorbants, sans que n'apparaissent des possibilités de résonances parasites qui vont dégrader les performances de la structure.
Cette structure nécessite l'assemblage de nombreuses pièces mécaniques ce qui conduit à un ensemble peu robuste.
Cette solution ne permet pas d'interconnecter simplement plusieurs amplificateurs élémentaires, notamment avec accès micro-rubans (configuration la plus répandue) répartis de façon radiale (disposition la plus pratique pour des un format cylindrique). De plus, elle présente une grande complexité de réalisation mécanique notamment dès que l'on cherchera à couvrir des fréquences utiles élevées et un encombrement réduit.

Par ailleurs, les performances annoncées avec 0.5dB de pertes d'insertion, sur une bande de fréquence de 2.5 à 10GHz ne sont pas suffisantes pour les applications visées

Un autre type de solution, plus récent, basé également sur la combinaison spatiale de puissance autour d'un guide d'onde coaxial et mieux adaptée pour des accès micro-rubans disposés en rayons a été proposé par exemple dans le document US2014/016788.

Cette solution permet de diviser ou recombiner la puissance vers/depuis plusieurs voies ou amplificateurs élémentaires, dans un encombrement réduit et sur une large bande de fréquence.

Toutefois, les résultats sur cette solution font apparaitre des dimensions et des pertes d'insertion trop importantes.

Dans cette structure, les amplificateurs élémentaires sont disposés en rayon, dans l'espace entre les deux conducteurs qui constituent un guide coaxial. Ce guide est largement surdimensionné pour pouvoir loger ces amplificateurs et les différentes voies parallèles qui réalisent les nécessaires transformations d'impédances vers les extrémités micro-rubans.

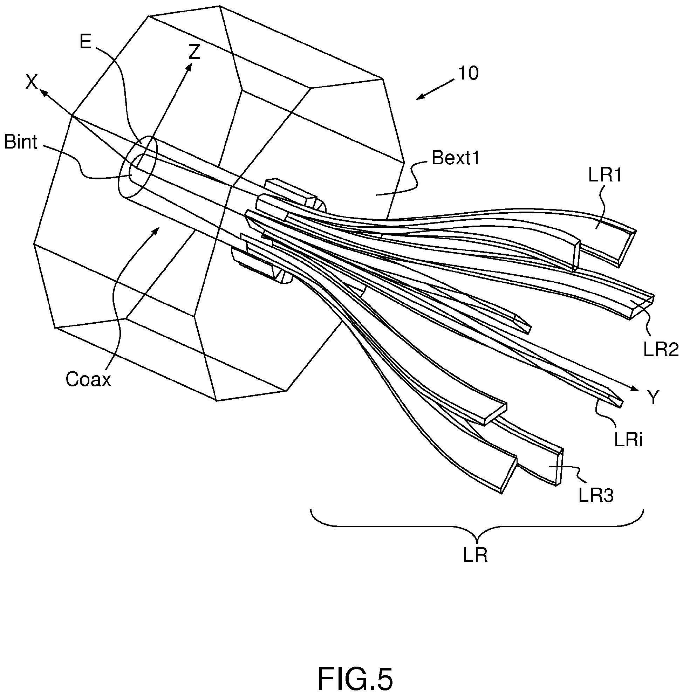

Les transformations d'impédances sont réalisées avec des lignes antipodales, telles que décrites sur la figure 5 du document, adaptées aux lignes coaxiales. Ces structures présentent deux plages métalliques disposées sur les faces opposées d'un substrat, ces plages représentent une structure qui s'apparente à une ligne fente, de haute impédance caractéristique, sur une extrémité et une ligne micro-ruban, de plus faible impédance caractéristique, sur l'autre extrémité. Une plage s'élargie progressivement de façon à réaliser la plan de masse et l'autre plage s'élargie puis se rétrécie pour finir par former la ligne de la structure micro-ruban.

Le guide coaxial est d'autant plus surdimensionné que le nombre d'amplificateurs élémentaires (ou de voies, ici les lignes antipodales) est important : Il faut nécessairement plus de place pour loger plus d'amplificateurs, mais ce n'est pas la seule raison car lorsque l'on accroit le nombre d'amplificateurs, alors, à impédance constante (valeur maximale) sur l'entrée de chaque voie, l'impédance caractéristique du guide coaxial est nécessairement plus basse, ce qui conduit également à surdimensionner le guide pour conserver le même espace coaxial. En effet, il faut augmenter les diamètres de la ligne coaxiale pour obtenir une impédance caractéristique plus basse avec un même espace entre l'âme (centre) et le corps (pourtour) du guide coaxial. En conséquence de l'apparition croissante de modes de propagations d'ordre supérieurs et des possibles résonances associées, les performances vont diminuer et l'encombrement va augmenter en fonction du nombre d'amplificateurs élémentaires et de la fréquence utile la plus haute. En outre, plus les diamètres du guide coaxial sont grands, plus il faut utiliser de voies ou d'amplificateurs pour minimiser les discontinuités. En d'autres termes, l'usage d'un guide coaxial de plus faible diamètre permet de couvrir de plus larges bandes de fréquences, avec des fréquences utiles plus hautes, ou bien nécessite un plus faible nombre d'amplificateurs élémentaires. Par exemple, en poussant ce raisonnement à l'extrême, un coaxial de dimension suffisamment petite pourrait même se contenter d'un seul amplificateur, ce qui constitue un cas très dissymétrique, qui est propice pour exciter des modes supérieurs ou des résonances...que l'on souhaite éviter sur un guide surdimensionné.

De ce point de vue, la structure décrite dans le document US2014/016788 nécessite un grand nombre d'amplificateurs pour assurer une large bande passante et une fréquence utile haute élevée.

Les inconvénients précités indiquent que les performances et l'encombrement de cette structure sont limités par ces deux éléments antagonistes : d'un côté il faut limiter le nombre d'amplificateurs pour limiter l'encombrement et assurer des performances suffisantes en haute fréquence (pertes d'insertion, rendement, ondulation du gain), et d'un autre côté il faut un nombre minimum d'amplificateurs pour assurer des performances RF suffisantes (puissance maximale, bande passante).

En d'autres termes, l'antagonisme sur le nombre plus ou moins important de voies ou d'amplificateurs vient du fait qu'il faut minimiser leur nombre pour que la structure soit compacte et peu pénalisée par les modes supérieurs et autres résonances parasites (fréquence maximale utile, pertes d'insertion, ondulations), et qu'il faut un maximum d'amplificateurs pour que la transition entre la partie coaxiale et antipodale soit performante (fréquence maximale utile, pertes d'insertion, ondulation, mais aussi puissance maximale).

Par ailleurs, la complexité de réalisation de cette structure est également importante, et elle est d'autant plus complexe que le nombre d'amplificateurs élémentaires est grand. De plus, cette structure nécessite l'assemblage de nombreuses pièces mécaniques ce qui conduit à un ensemble peu robuste.

Les documents CN102280681 et US5256988 divulguent différentes implémentations d'un système diviseur de puissance pour faire une amplification distribuée d'un signal hyperfréquence. Le diviseur utilise la technologie coaxiale et comprend une transition avec une pluralité de lignes ruban.

Un but de la présente invention est de palier aux inconvénients précités en proposant un système diviseur/combineur monomode présentant une bande passante large au voisinage d'une fréquence utile, peu encombrant et réalisé à partir d'un nombre réduit de pièces mécaniques, ce qui permet une tenue mécanique et une robustesse accrue de l'ensemble.

## DESCRIPTION DE L'INVENTION

La présente invention a pour objet un système diviseur/combineur   pour   signal   hyperfréquence comprenant :

- une ligne coaxiale comprenant un bloc intérieur s'étendant longitudinalement le long d'un axe Y, présentant une surface conductrice et s'insérant dans un bloc extérieur dont des parois des cavités internes sont conductrices, le bloc intérieur étant séparé du bloc extérieur par un espace isolant, ladite ligne coaxiale présentant une extrémité de raccordement,
- une pluralité de N lignes ruban, chaque ligne ruban comprenant une première et une deuxième bande conductrice disposées en regard de part et d'autre d'un substrat isolant ou diélectrique,
- une des extrémités de chaque ligne ruban, dénommée première extrémité, étant disposée de façon tangentielle sur le pourtour du bloc intérieur dans ledit espace à l'extrémité de raccordement de la ligne coaxiale, la première et la deuxième bande conductrice à la première extrémité de la ligne ruban étant respectivement en contact électrique avec le bloc intérieur et le bloc extérieur, le bloc extérieur étant en outre relié à la masse du système .

Avantageusement, chaque première extrémité des lignes ruban présente une impédance adaptée à l'impédance de la ligne coaxiale à l'extrémité de raccordement.

Avantageusement, une impédance à la première extrémité de chaque ligne ruban est sensiblement égale à N fois l'impédance de la ligne coaxiale à son extrémité de raccordement, de manière à contribuer à adapter l'impédance de chaque première extrémité des lignes ruban à l'impédance de la ligne coaxiale à son extrémité de raccordement.

Selon une première variante, le bloc intérieur et le bloc extérieur présentent, à l'extrémité de raccordement, des évidements situés entre des lignes ruban adjacentes, de manière à contribuer à ladite adaptation d'impédance.

Selon une autre variante, pour chaque ligne ruban, la largeur pour laquelle les deux bandes conductrices sont en regard et leurs épaisseurs respectives sont déterminées de manière à contribuer à ladite adaptation d'impédance.

Selon une autre variante, pour un signal hyperfréquence en bande X, la largeur des bandes conductrices est inférieure ou égale à 1 mm et les épaisseurs sont supérieures ou égales à 80 $\mu$m.

Selon une autre variante les bandes conductrices en regard sont décalées latéralement l'une par rapport à l'autre à la première extrémité de manière à contribuer à ladite adaptation d'impédance.

Avantageusement, le bloc intérieur de la ligne coaxiale est de forme conique. Avantageusement, la ligne coaxiale est configurée pour être monomode dans une bande de fréquence utile du système.

Selon un mode de réalisation, le système est réalisé dans un bloc comprenant le bloc extérieur, et dont des parois des cavités internes sont conductrices, le système comprenant en outre :

- une cavité jouxtant l'extrémité de raccordement de la ligne coaxiale, les lignes ruban étant fixées au bloc et,
- une pluralité de N tunnels creusés dans le bloc, chaque tunnel comprenant une ligne ruban associée.

Avantageusement la cavité est dimensionnée pour ne pas propager de modes parasites et/ou ne pas générer de résonances dans une bande de fréquences utiles du système.

Préférentiellement, les tunnels sont configurés de manière à ce qu'une deuxième extrémité de chaque ligne ruban soit disposée sur un cercle présentant un diamètre supérieur au diamètre de la ligne coaxiale. Avantageusement chaque ligne ruban est configurée de manière à présenter à sa deuxième extrémité une impédance inférieure à l'impédance de sa première extrémité.

Selon un mode de réalisation le système comprend en outre un absorbant et/ou des couches résistives disposés dans la cavité entre les lignes ruban et/ou dans au moins une partie des tunnels.

L'invention a également pour objet un amplificateur hyperfréquence comprenant :

- un premier système diviseur selon l'invention apte à transporter un signal hyperfréquence d'une première ligne coaxiale vers une première pluralité de N lignes ruban,
- une pluralité de N amplificateurs du signal hyperfréquence couplés aux N premières lignes ruban,
- un deuxième système combineur selon l'invention présentant une deuxième pluralité de lignes ruban couplées auxdits amplificateurs, apte à transporter le signal hyperfréquence amplifié des deuxièmes lignes ruban vers une deuxième ligne coaxiale.

D'autres caractéristiques, buts et avantages de la présente invention apparaîtront à la lecture de la description détaillée qui va suivre et en regard des dessins annexés donnés à titre d'exemples non limitatifs et sur lesquels :

La figure 1 illustre un système diviseur/combineur 10 selon l'invention.
La figure 2 illustre une ligne ruban selon l'invention.
La figure 3 illustre des lignes parallèle classiques pour lesquelles les bandes conductrices sont disposées du même côté du substrat.
La figure 4 illustre une ligne pour laquelle une seule bande conductrice est en regard d'une masse de grande dimension.
La figure 5 schématise une vue en perspective du système selon l'invention.
La figure 6 illustre une variante d'un système diviseur/combineur selon l'invention comprenant des évidements.

La figure 7 schématise une vue en coupe de la variante d'un système diviseur/combineur de la figure 6.

La figure 8 illustre une autre variante combinée à la variante de la figure 6 dans laquelle des lignes ruban sont décalées latéralement l'une par rapport à l'autre.

La figure 9 illustre une ligne ruban selon l'invention.

La figure 10 schématise un système selon l'invention comprenant une cavité jouxtant l'extrémité de raccordement de la ligne coaxiale.

La figure 11 illustre la pluralité de tunnels d'un système selon l'invention.

La figure 12 schématise une vue en perspective d'une variante du système 10 réalisé dans un seul bloc.

La figure 13 illustre un substrat souple des lignes ruban.

La figure 14 illustre un substrat des lignes ruban souple et présentant une torsion.

La figure 15 schématise une vue de coupe avec des lignes ruban présentant une torsion de 90° en sortie des tunnels selon l'invention.

La figure 16 illustre un système selon l'invention comprenant un absorbant et/ou des couches résistives disposés dans la cavité entre les lignes ruban et/ou dans au moins une partie des tunnels.

La figure 17 schématise un amplificateur hyperfréquence utilisant système diviseur et un système combineur selon l'invention.

## DESCRIPTION DETAILLEE DE L'INVENTION

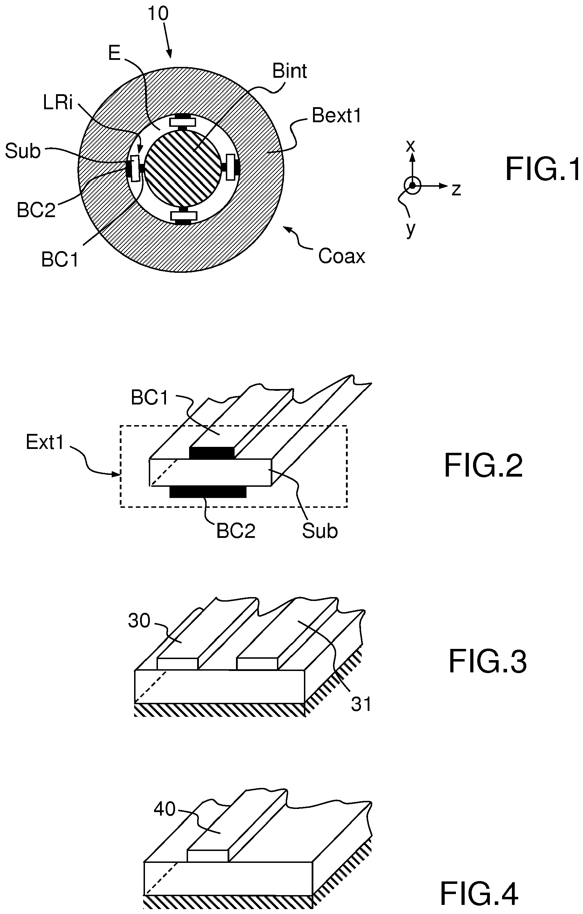

Un système diviseur/combineur 10 selon l'invention est illustré figure 1. Ce système fonctionne typiquement pour un signal hyperfréquence appartenant aux bandes L à $K_A$, c'est-à-dire présentant une fréquence comprise entre 1 GHz et 30 GHz, et sur une bande passante typiquement d'une octave.

Le diviseur/combineur 10 comprend une ligne coaxiale Coax comprenant un bloc intérieur Bint, également dénommé « âme » de la ligne, s'étendant longitudinalement le long d'un axe Y. Le bloc intérieur, typiquement de forme allongée cylindrique ou conique, présente une surface conductrice, typiquement une couche d'argent et s'insère dans un bloc extérieur Bext1, également dénommé «corps » de la ligne, dont les parois des cavités internes sont conductrices. Le bloc extérieur est de forme allongée, par exemple de section cylindrique circulaire pour polyédrique.

En variante, le bloc extérieur est réalisé dans la masse d'un matériau conducteur, par exemple du cuivre. Le bloc intérieur Bint est séparé du bloc extérieur Bext1 par un espace E isolant, typiquement de l'air.

La ligne coaxiale présente une extrémité dénommée extrémité de raccordement.

Le combineur/ diviseur comprend en outre une pluralité LR de N lignes ruban LR1, LR2, ... LRN, chaque ligne ruban, également illustrée figure 2, comprenant une première bande conductrice BC1 et une deuxième bande conductrice BC2 disposées en regard de part et d'autre d'un substrat Sub isolant ou diélectrique. Chaque ligne ruban comprend une première extrémité Ext1 apte à se raccorder à l'extrémité de raccordement de la ligne coaxiale. Le raccordement s'effectue selon la géométrie suivante : les premières extrémités Ext1 sont insérées de façon tangentielle sur le pourtour du bloc intérieur Bint dans l'espace E à l'extrémité de raccordement de la ligne coaxiale Coax, comme illustré figure 1. La première bande conductrice BC1 à la première extrémité Ext1 est en contact électrique avec le bloc intérieur Bint et la deuxième bande conductrice BC2 de la ligne ruban à la première extrémité Ext1 est en contact électrique avec le bloc extérieur Bext1. En outre le bloc extérieur Bext1, et donc les bandes conductrices BC2, est relié à la masse du système.

La division/recombinaison spatiale de puissance s'effectue dans l'interface entre la ligne coaxiale Coax et les lignes ruban. Dans la configuration diviseur, un signal hyperfréquence se propageant dans la ligne coaxiale se trouve couplé aux N lignes ruban, et se propage ensuite le long de ces lignes. En configuration combineur, une pluralité de signaux hyperfréquences se propageant dans les lignes ruban se recombinent pour se propager dans la ligne coaxiale. N est typiquement compris entre 4 et 15.

La ligne coaxiale n'a pas besoin d'être surdimensionnée par rapport à la longueur d'onde du signal hyperfréquence utile, et l'usage d'un guide coaxial de plus faible diamètre (par rapport à l'état de la technique) permet d'obtenir de plus larges bandes de fréquence, avec des fréquences utiles plus hautes, ou une bande de fréquence équivalente avec un nombre plus faible de voies (voir également plus loin sur la figure 5).

Une ligne coaxiale de faible diamètre combinée au raccordement réalisé dans l'espace E permet par ailleurs au système 10 selon l'invention de présenter un encombrement réduit et un format compact.

Typiquement, pour un signal en bande X, la ligne coaxiale présente un diamètre, défini par le diamètre du bloc intérieur plus de l'espace, d'environ 8 mm. Le diamètre à ne pas dépasser sera évalué par rapport aux relations qui permettent de déterminer les fréquences de résonances et les modes supérieurs : Par exemple, dans une cavité cylindrique on évite de dépasser un diamètre de c/f x 0,59 [m] et dans un guide coaxial la somme des deux diamètres (celui de l'âme + celui du corps) ne doit pas dépasser c/f x 0.64 [m], ou c est la vitesse [m/s] de la lumière dans le milieu isolant (air, vide, diélectrique...) et f la fréquence [Hz] utile maximale.

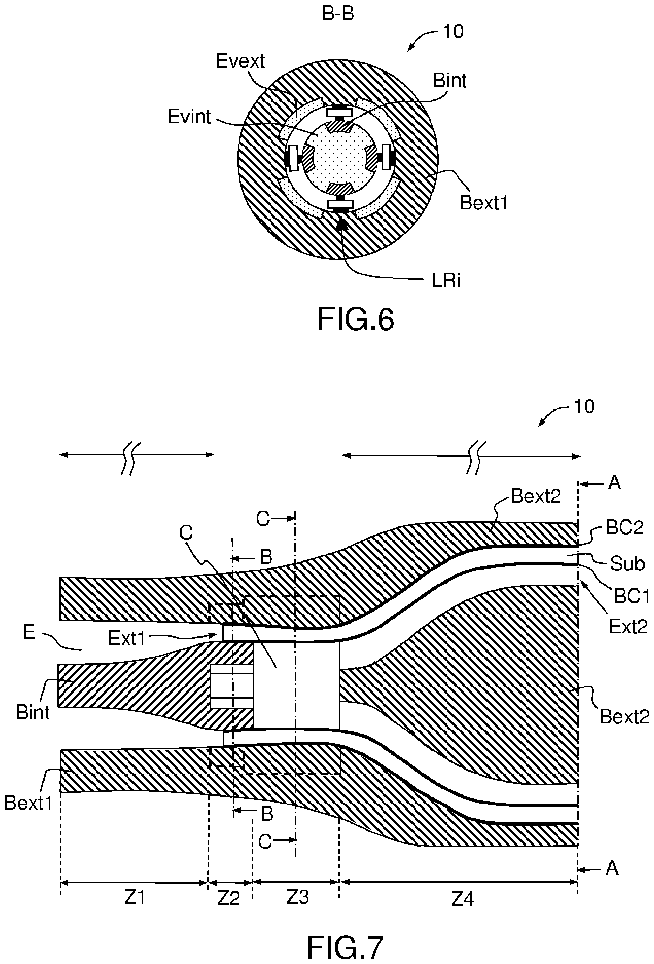

Une ligne ruban utilisée dans l'invention est dénommées ligne parallèle couplée sur le côté large (« broadside coupled lines » en terminologie anglo-saxonne), car celles-ci s'adaptent bien à l'interface coaxiale. La propagation sur les lignes parallèles couplées sur le côté large s'apparente à celle des lignes bifilaires. En revanche lorsque l'un des rubans est plaqué sur un conducteur plus large, par exemple sur la paroi métallique d'un élément de plus grande dimension tel que B (figure 7), alors la propagation s'apparente à celle d'une ligne micro-ruban.

Typiquement le substrat est un substrat diélectrique de type organique (PTFE et verre) et les bandes conductrices sont en cuivre avec une finition argentée.

Certaines dimensions de ces lignes peuvent être optimisées dans le contexte de l'invention, comme décrit plus loin.

Le fait que chaque bande conductrice BC2 et le bloc extérieur avec lequel elles sont en contact électrique soient reliés à la masse du système présente plusieurs avantages. En courant continu ou basse-fréquence ils sont au même potentiel, ce qui est préférable.

De plus chaque bande conductrice BC1 est reliée à l'âme de la structure coaxiale Bint et est constamment isolée de la masse de la structure Bext.

En outre la masse est localisée sur l'extérieur de la structure du système et sur chaque bandes conductrices BC2 des lignes ruban LRi. En haute fréquence, il n'y a pas de plan de masse radiofréquence unique mais une pluralité de masses radiofréquence, une sur chaque ligne ruban. Ces masses sont directement accessibles via les bandes individuelles BC2, ce qui permet de connecter à une deuxième extrémité de chaque lignes ruban LRi des équipements (tels des amplificateurs) associés, dont la masse peut être reliée directement à la bande conductrice associée. La connexion est aisée et sans risque de court circuit.

Ces lignes ruban selon l'invention ne doivent pas être confondues avec d'une part les lignes parallèle classiques illustrées figure 3 pour lesquelles les bandes conductrices 30 et 31 sont disposées du même côté du substrat avec ou sans plan de masse du côté opposé, et d'autre part avec un ruban tel qu'illustré figure 4, pour lequel une seule bande conductrice 40 est en regard d'une masse de grande dimension. Lorsque ce type de ruban est utilisé, en haute fréquence la masse n'est pas définie de manière individuelle mais il existe un plan de masse commun à tous les rubans, et la connexion d'équipements individuels associés à chaque ruban est problématique.

Ce ne sont pas non plus des lignes antipodales comme dans l'état de la technique décrit précédemment. Chaque ligne ruban selon l'invention est un ruban ou « strip » dès le départ, il n'y pas de transformation géométrique du ruban, tout au plus une variation de largeur, comme décrit plus loin.

La géométrie des lignes ruban utilisées pour l'invention permet d'assurer la continuité électrique avec la ligne coaxiale par un raccordement dans l'espace E. Les configurations des champs électromagnétiques propagés sur les lignes ruban et sur la ligne coaxiale sont proches et en conséquence il est possible d'optimiser efficacement les pertes d'insertion.

Une vue en perspective du système 10 est schématisée sur la figure 5. On constate sur cette vue que le diamètre interne de la partie coaxiale ne s'évase pas le long de la partie coaxiale, ce qui préserve le fonctionnement monomode, et donc des performances optimales et une bande de fréquence utile la plus large possible, comme expliqué plus haut. Ainsi le diamètre interne de la partie coaxiale est tel que seul le mode fondamental se propage dans la partie coaxiale du système.

Préférentiellement, la ligne coaxiale Coax est configurée pour être monomode, dans une bande de fréquence utile du système 10, afin d'éviter les modes de propagation supérieurs et les modes parasites. Typiquement seul le mode fondamental se propage. Plus les fréquence de coupure des modes supérieurs sont éloignés de la bande de fréquence utile, plus le combineur/diviseur est performant. Cela implique des dimensions maximales à ne pas dépasser. Entre autre, la dimension réduite de la ligne coaxiale, non surdimensionnée, permet à la bande de fréquence utile d'être située au dessous des résonnances parasites et autres modes de propagation non fondamentaux. Par exemple pour une fréquence utile de 14 GHz, un diamètre maximum (âme plus espace E) est de 8mm.

Afin d'optimiser la transition entre la ligne coaxiale Coax et les N lignes ruban LR1... LRN, c'est-à-dire de diminuer les pertes d'insertion, il convient de réaliser une adaptation d'impédance entre la ligne coaxiale à son extrémité de raccordement et chaque ligne ruban à sa première extrémité, c'est-à-dire que chaque première extrémité Ext1 des lignes ruban présente une impédance adaptée à l'impédance de la ligne coaxiale Coax à l'extrémité de raccordement.

Avantageusement, pour contribuer à l'adaptation l'impédance, l'impédance $Z_{ext1}$ à la première extrémité Ext1 de chaque ligne ruban est sensiblement égale à N fois l'impédance de la ligne coaxiale $Z_{c/rac}$ à son extrémité de raccordement :

$$Z_{ext1} = N. \, Z_{c/rac} \quad (1)$$

Pour obtenir l'égalité (1), une première variante est de diminuer l'impédance de la ligne coaxiale à son extrémité de raccordement. La ligne coaxiale effectue dans ce cas une transformation d'impédance qui diminue progressivement l'impédance à partir de celle de son extrémité externe, typiquement 50 Ohms, vers une impédance plus basse à l'extrémité de raccordement $Z_{c/rac}$, typiquement 20 ou 30 Ohms. Ceci peut être réalisé par un bloc intérieur Bint de forme conique.

La forme conique du bloc intérieur, c'est-à-dire de l'âme de la ligne coaxiale, permet selon une variante de fixer les lignes par simple compression (montage en force) de celles-ci dans l'intervalle coaxial E.

Plus le nombre de voies ruban est élevé, plus l'impédance $Z_{c/rac}$ de la ligne coaxiale à l'extrémité de raccordement doit être basse pour que l'adaptation d'impédance puisse être aisément obtenue.

La partie coaxiale étant raccordée vers N lignes ruban, l'impédance caractéristique $Zext1$ à la base de chacune de ces lignes ruban doit être approximativement de Zc/rac xN.

Une deuxième variante, qui est avantageusement combinée à la première variante, est donc d'augmenter l'impédance de chaque ligne ruban à sa première extrémité. Par exemple pour une impédance Zc/rac de 30 Ohms et 10 voies de ligne ruban, l'impédance à la première extrémité de chaque ligne ruban doit être sensiblement égale à 300 Ohms.

Les champs EM des lignes ruban et des secteurs de ligne coaxiale sont similaires et par conséquent, pour des dimensions du même ordre de grandeur, cette transition d'une ligne à l'autre ne représente pas une discontinuité majeure.

Selon une première variante, le bloc intérieur Bint et le bloc extérieur Bext1 présentent, à l'extrémité de raccordement, des évidements Evint, Evext situés entre les lignes adjacentes, de manière à contribuer à ladite adaptation d'impédance, comme illustré figure 6 (coupe B-B de la figure 7). La zone d'évidement de la ligne coaxiale à son extrémité de raccordement est également illustrée sur le schéma en coupe du système 10 de la figure 7, correspondant à une variante décrite plus loin, et correspond à la zone Z2, la zone Z1 correspondant à la zone dans laquelle la ligne coaxiale est classique. La partie centrale du bloc intérieur en regard de la zone d'évidement Z2 est avantageusement également évidée. Ces évidements sont réalisés par exemple par usinage de la ligne coaxiale dans la zone Z2 de transition avec les lignes ruban. L'introduction des lignes ruban dans la ligne coaxiale diminuent localement l'impédance de cette dernière. Cela résulte d'une augmentation locale du couplage entre Bint et Bext1 par la présence des lignes ruban. Les évidements permettent de compenser cela et de réduire le couplage entre Bint et Bext1.

Selon une deuxième variante, l'impédance caractéristique des lignes micro-ruban est encore augmentée localement à l'extrémité Ext1 en introduisant des perçages longitudinaux dans les substrats Sub à leur extrémité. Ces perçages apportent plus de souplesse pour mieux s'adapter à la pression d'assemblage et aux variations des dimensions liées aux variations de température.

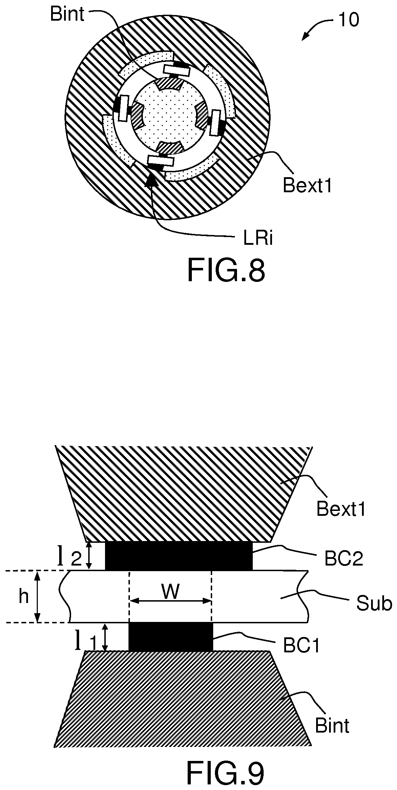

Selon une troisième variante illustrée figure 8, avantageusement combinée aux variantes précédentes, les bandes conductrices en regard BC1 et BC2 des lignes ruban sont avantageusement décalées latéralement l'une par rapport à l'autre à la première extrémité, pour augmenter leur impédance caractéristique. Le décalage éloigne les deux rubans et par conséquent augmente l'impédance caractéristique de la ligne.

On prendra soin de réaliser le décalage de façon à ce que la torsion des lignes (voir plus loin) renforce le contact des lignes au raccordement avec la partie coaxiale Coax.

Le décalage est principalement utile à l'extrémité Ext1, les bandes se superposent ensuite progressivement le long des lignes.

Selon une autre variante illustrée figure 9, pour chaque ligne ruban, la largeur w pour laquelle les deux bandes conductrices BC1 et BC2 sont en regard et leurs épaisseurs respectives I1 let I2 sont déterminées de manière à contribuer à l'adaptation d'impédance, dans la zone de transition, c'est-à-dire à la première extrémité. Typiquement, pour augmenter localement l'impédance de la ligne ruban à sa première extrémité, les épaisseurs I1 et I2 doivent être plus épaisses que pour une ligne ruban standard, et la largeur w plus faible.

En effet l'impédance de la ligne ruban est localement proportionnelle à h/w, et lorsqu'elle est mise en contact électrique avec les blocs intérieur et extérieur, l'impédance a tendance à baisser d'autant plus que I1, I2 sont faibles.

Par exemple, pour un signal hyperfréquence en bande X, la largeur w est inférieure ou égale à 1 mm, et les épaisseurs I1, I2 sont supérieures ou égales à 80 $\mu$m,

Selon un mode de réalisation illustré figure 7 le système 10 selon l'invention est réalisé dans un bloc B qui comprend la partie Bext1 et la prolongation de celle-ci Bext2. Toutes les parois des cavités internes sont conductrices,.

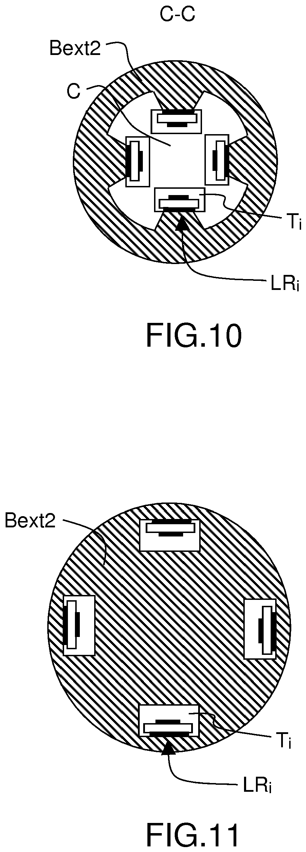

Le système comprend également une cavité C jouxtant l'extrémité de raccordement de la ligne coaxiale, correspondant au tronçon Z3 de la figure 7. Les lignes ruban LR1, LR2 ... sont fixées au bloc, tel qu'illustré figure 10 correspondant à la coupe C-C de la figure 7.

Les tronçons Z1, Z2 et Z3 sont tous de faible diamètre, le diamètre intérieur est sensiblement constant, il n'y a pas d'évasement, ce qui assure au système un fonctionnement monomode et de faibles dimensions. De plus on remarque sur ce schéma qu'il n'existe aucun contact électrique entre le bloc intérieur Bint, relié à un potentiel choisi, et le bloc extérieur Bext (Bext1 et Bext2) relié à la masse du système diviseur/recombineur.

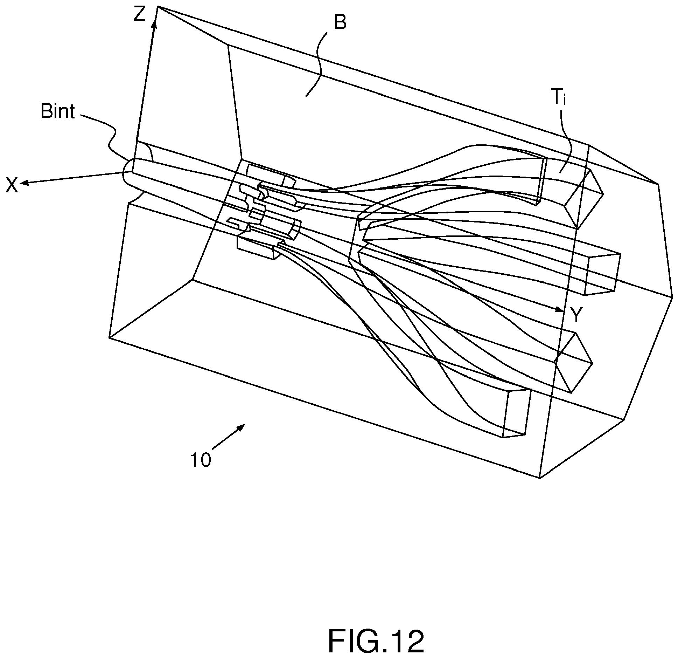

Le système comprend en outre une pluralité de N tunnels T1, T2... TN creusés dans la partie Bext2 du bloc B, correspondant au tronçon Z4 de la figure 7 et illustré figure 11 (coupe A-A de la figure 7). Chaque tunnel Ti comprenant une ligne ruban associée. Avantageusement, les tunnels sont configurés de manière à ce qu'une deuxième extrémité Ext2 de chaque ligne ruban soit disposée sur un cercle présentant un diamètre supérieur au diamètre de la ligne coaxiale (figure 12); les lignes ruban sont ainsi éloignées les une des autres pour que chaque voie soit amplifiée séparément. La bande conductrice initialement reliée à Bext1 de la partie coaxiale est solidaire (collage, brasage) et en contact électrique avec une paroi du tunnel et l'autre bande conductrice initialement reliée à Bint reste sans contact avec Bext2 (située plus au centre sur les coupes de la figure 12). Selon un mode de réalisation, pour faciliter la fabrication, les parties Bext1 et Bext2 sont réalisées en une fois et constituent un bloc unique.

Une vue en perspective du système 10 réalisé dans un seul bloc B est schématisée figure 12. Cette vue représente les creux présents dans le bloc B.

La cavité C pseudo cylindrique, typiquement remplie d'air, réalise la transition entre les premières extrémités des lignes ruban concentrées autour de l'extrémité de raccordement de la ligne coaxiale de faible diamètre et les différents tunnels Ti accueillant les lignes ruban en évitant les courts-circuits et permettant d'éloigner ces lignes ruban les une des autres pour réaliser un amplificateur décrit plus loin. La cavité est dimensionnée de taille suffisamment petite pour ne pas générer de modes supérieurs ou de résonnances parasites dans la bande de fréquence utile. Ce dimensionnement est à réaliser avec précaution car la cavité C est le siège d'une résonnance aigüe qui peut typiquement constituer une fréquence de coupure haute pour l'ensemble de la structure.

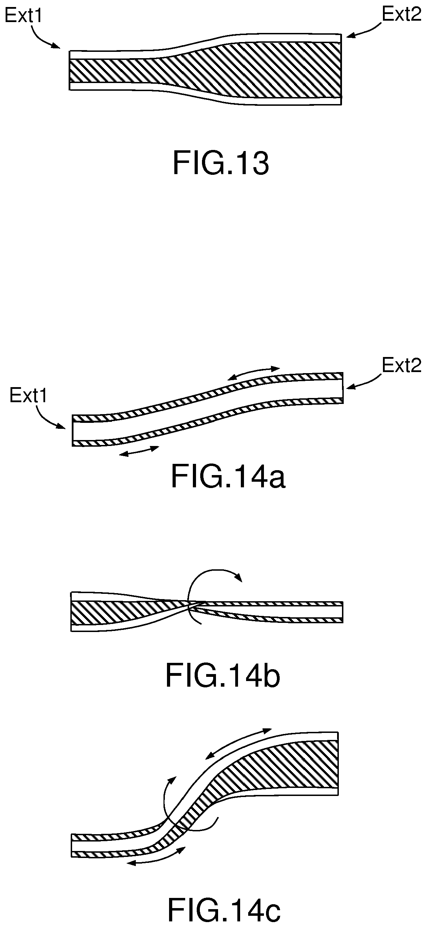

Avantageusement le substrat Sub des lignes ruban est souple pour permettre une adaptation aisée au tunnel correspondant et pour s'adapter plus facilement aux contraintes liées aux variations de températures et aux dilatations différentielles des différents éléments assemblés, tel qu'illustré figure 13.

De plus avantageusement le substrat souple est tel qu'il permet les flexions et les torsions combinées lors de leur assemblage, sans être endommagé ou fragilisé, tel qu'illustré figure 14. Ainsi typiquement chaque ligne ruban présente deux flexions d'environ 30° dans le tunnel associé.

En variante, un substrat constitué de plusieurs couches diélectriques permet d'optimiser les possibilités de torsion et de flexion combinées de celui-ci, tout en obtenant des caractéristiques électriques appropriées (faible permittivité, faibles pertes diélectriques, tenue aux forts champs électriques, conductivité thermique la plus élevée possible).

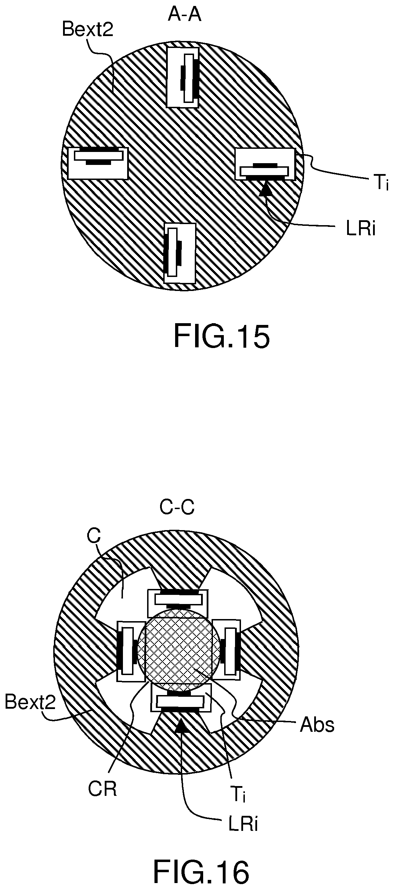

La figure 15 schématise une vue de coupe A-A avec des lignes ruban présentant une torsion de 90° en sortie de tunnel. Une torsion des lignes permet de disposer les amplificateurs associés (voir plus loin) de façon compacte.

Le bloc B peut être en plastique, avec des parois recouvertes d'argent, ou tout en cuivre.

Avantageusement la partie mécanique du bloc B qui comprend les lignes ruban, présentant une forme complexe mais peu sensible en terme de précision de réalisation, est réalisée par impression 3D à base de divers matériaux, conducteurs, céramique ou composites. Selon un mode de réalisation, le bloc B est constitué de plusieurs parties, et selon un autre mode de réalisation, le bloc B est constitué d'un bloc unique (monobloc) réalisé

Avantageusement, le système 10 comprend un système de refroidissement, typiquement un système de caloduc en serpentin autour de la zone d'échauffement maximal située sur les lignes ruban, juste après leur transition avec la partie coaxiale, c'est-à-dire dans la cavité C.

Avantageusement le système 10 comprend en outre un absorbant Abs et/ou des couches résistives CR disposés dans la cavité C entre les lignes ruban et/ou dans au moins une partie des tunnels, tel qu'illustré figure 16. Les éléments résistifs CR forment approximativement un anneau sur lequel les rubans reliés à l'âme de la ligne coaxiale sont en contact tangentiel. De la même façon, l'absorbant Abs forme approximativement un cylindre sur lequel les rubans reliés à l'âme de la ligne coaxiale sont en contact tangentiel.

Ces résistances et/ou ces absorbant isolent les voies entre elles, ce qui peut s'avérer utile pour stabiliser et contrer les dissymétries physiques et électriques du module amplificateur (voir plus loin).

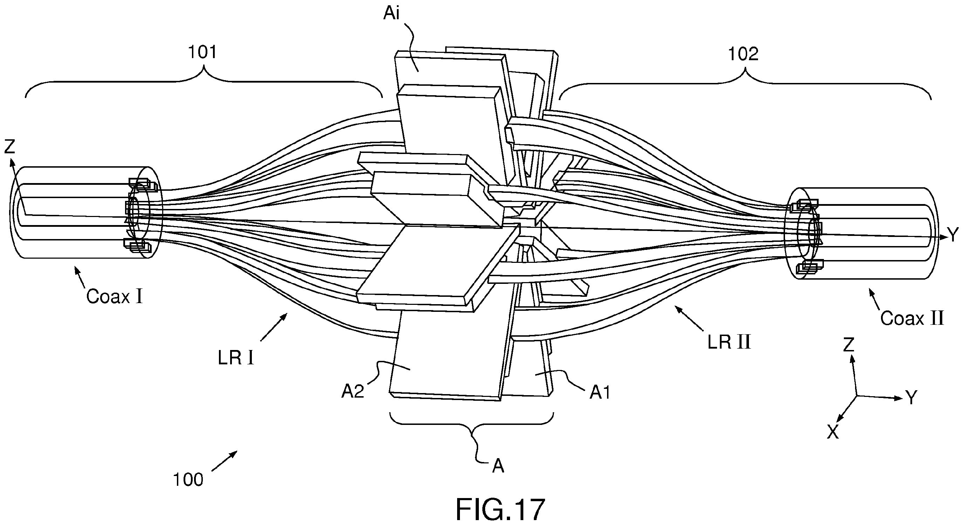

L'invention a également pour objet un amplificateur hyperfréquence 100 utilisant système diviseur et un système combineur selon l'invention, schématisé figure 17.

L'amplificateur hyperfréquence 100 comprend un premier système 101) diviseur selon l'invention apte à transporter un signal hyperfréquence d'une première ligne coaxiale Coaxl vers une première pluralité de N lignes ruban LRI. Le système 100 comprend également une pluralité A de N amplificateurs élémentaires A1, A2, ... AN du signal hyperfréquence couplés aux N premières lignes ruban et un deuxième système 102 combineur selon l'invention présentant une deuxième pluralité de lignes ruban LRII couplées aux amplificateurs élémentaires, apte à transporter le signal hyperfréquence amplifié des deuxièmes lignes ruban vers une deuxième ligne coaxiale Coaxll.

Les amplificateurs élémentaires sont typiquement réalisés avec une technologie de semiconducteurs AsGa ou GaN, intégrés avec leurs réseaux d'adaptation dans un boitier standard, avec un dissipateur thermique qui fait aussi office de plan de masse et des accès RF aptes à se raccorder avec des lignes ruban par brasure.

Avantageusement, chaque ligne ruban est configurée de manière à présenter à sa deuxième extrémité une impédance inférieure à l'impédance de sa première extrémité Ext1. En effet, les impédances caractéristiques des amplificateurs sont typiquement de 50 Ohms. Il convient donc de transformer l'impédance entre la première extrémité Ext1 (voir formule (1) N x Zc/rac) typiquement de l'ordre de 300 Ohms et la deuxième extrémité couplée à l'amplificateur, qui doit donc être proche de 50 Ohms. Ainsi, la longueur de ligne nécessaire pour réaliser cette transformation d'impédance est mise à profit pour réaliser la liaison vers les amplificateurs élémentaires, dont les ports d'accès sont centrés sur un cercle de plus grand diamètre (offset suivant le rayon) et dont les accès présentent également une rotation des champs EM suivant l'axe longitudinal, typiquement de 90°.

Suivant les modes de réalisation des lignes coaxiales et ruban, ainsi que suivant les puissances RF visées, les rapports de transformations d'impédance seront optimisés/répartis entre ces deux types de lignes.

Un exemple de dimensionnement pour une bande de fréquence utile correspondant à la bande X 8-12 GHz est donné ci-dessous.

L'accès coaxial présente une impédance caractéristique standard de 50 Ohms. La ligne coaxiale Coax réalise une diminution d'impédance, par exemple vers 20 Ohms, sur une longueur adéquate pour couvrir la bande de fréquence utile, notamment pour assurer la fréquence de coupure basse : 20mm assurent une coupure basse située vers 8GHz. La transformation d'impédance est mise en œuvre suivant la méthode classique publiée par Klopfenstein en 1956. Cette méthode permet de déterminer la courbe de variation d'impédance optimale pour concevoir une transformation d'impédance. Les diamètres de cette ligne coaxiale sont choisis inférieurs aux diamètres auxquels les modes supérieurs peuvent apparaitre, donc au-dessus de la fréquence de coupure haute utile : la structure propage uniquement le mode fondamental dans la bande de fréquence utile. Pour un diamètre de blindage interne de 8mm (âme plus espace E), le premier mode parasite apparait vers 14GHz du côté basse impédance, situé au-delà de 12 GHz.

N=8 lignes ruban sont disposées régulièrement dans l'intervalle entre l'âme et le corps de la ligne coaxiale. A cette extrémité Ext1, leur impédance est proche de 20x8=160 Ohms.

Ces lignes ruban réalisent ensuite une diminution d'impédance, typiquement vers 50 ohms sur les accès des amplificateurs unitaires, sur une longueur adéquate pour couvrir la bande de fréquence utile et pour réaliser les courbures et la torsion nécessaires : une longueur de 44mm remplit ces conditions. La transformation d'impédance est mise en œuvre suivant la méthode Klopfenstein précitée. Les rubans sont constitués de pistes en cuivre, d'une épaisseur de 0.1mm et d'une largeur minimum (zone T2 de la figure 7) de 0.6mm. Le substrat d'épaisseur 0.9mm est composé de Polytetrafluoroethylene (ou PTFE ou Teflon) et de fibre de verre.

La longueur de la cavité cylindrique C dans laquelle les lignes ruban se séparent est fixée à 20mm, ce qui place la première résonance parasite largement au-dessus de la bande de fréquence utile, vers 18,4GHz.

**Revendications**

1. Système diviseur/combineur pour signal hyperfréquence (10) comprenant :

   - une ligne coaxiale (Coax) comprenant un bloc intérieur (Bint) s'étendant longitudinalement le long d'un axe Y, présentant une surface conductrice et s'insérant dans un bloc extérieur (Bext1) dont des parois des cavités internes sont conductrices, le bloc intérieur étant séparé du bloc extérieur par un espace (E) isolant, ladite ligne coaxiale présentant une extrémité de raccordement,
   - une pluralité (LR) de N lignes ruban (LR1, LR2, ... LRN), chaque ligne ruban comprenant une première (BC1) et une deuxième (BC2) bande conductrice disposées en regard de part et d'autre d'un substrat (Sub) isolant ou diélectrique,
   - une des extrémités de chaque ligne ruban, dénommée première extrémité (Ext1), étant disposée de façon tangentielle sur le pourtour du bloc intérieur (Bint) dans ledit espace (E) à l'extrémité de raccordement de la ligne coaxiale (Coax), la première (BC1) et la deuxième (BC2) bande conductrice à la première extrémité (Ext1) de la ligne ruban étant respectivement en contact électrique avec le bloc intérieur (Bint) et le bloc extérieur (Bext1), le bloc extérieur étant en outre relié à une masse du système,
   - le bloc extérieur (Bext1) se prolongeant longitudinalement selon l'axe Y du côté opposé à ladite première extrémité,

   **caractérisé en ce que**
   lesdites deuxième bandes conductrices (BC2) sont toujours en contact électrique avec une paroi interne conductrice de ladite prolongation (Bext2) dudit bloc extérieur.

2. Système selon la revendication 1 dans lequel chaque première extrémité des lignes ruban présente une impédance adaptée à l'impédance de la ligne coaxiale à l'extrémité de raccordement.

3. Système selon la revendication 2 dans lequel une impédance à la première extrémité (Ext1) de chaque ligne ruban est sensiblement égale à N fois l'impédance de la ligne coaxiale (Coax) à son extrémité de raccordement, de manière à contribuer à adapter l'impédance de chaque première extrémité des lignes ruban à l'impédance de la ligne coaxiale à son extrémité de raccordement.

4. Système selon l'une des revendications 2 ou 3 dans lequel le bloc intérieur et le bloc extérieur présentent, à l'extrémité de raccordement, des évidements (Evint, Evext) situés entre des lignes ruban adjacentes, de manière à contribuer à ladite adaptation d'impédance.

5. Système selon l'une des revendications 2 à 4 dans lequel, pour chaque ligne ruban, la largeur (w) pour laquelle les deux bandes conductrices (BC1, BC2) sont en regard et leurs épaisseurs respectives (l1,l2) sont déterminées de manière à contribuer à ladite adaptation d'impédance.

6. Système selon la revendication 5 adapté pour un signal hyperfréquence en bande X, dans lequel ladite largeur (w) est inférieure ou égale à 1 mm et lesdites épaisseurs (l1,l2) sont supérieures ou éga-

les à 80 μm.

7. Système selon l'une des revendications 2 à 6 dans lequel les bandes conductrices en regard sont décalées latéralement l'une par rapport à l'autre à la première extrémité de manière à contribuer à ladite adaptation d'impédance.

8. Système selon l'une des revendications précédentes dans lequel le bloc intérieur de la ligne coaxiale est de forme conique.

9. Système selon l'une des revendications précédentes dans lequel la ligne coaxiale est configurée pour être monomode dans une bande de fréquence utile du système.

10. Système selon l'une des revendications précédentes réalisé dans un bloc (B) comprenant le bloc extérieur (Bext1), et dont des parois des cavités internes sont conductrices, ledit système comprenant en outre :

   - une cavité (C) jouxtant l'extrémité de raccordement de la ligne coaxiale, les lignes ruban étant fixées au bloc et,
   - une pluralité de N tunnels (T1, T2... TN) creusés dans ledit bloc (B), chaque tunnel comprenant une ligne ruban associée.

11. Système selon la revendication 10 dans lequel ladite cavité est dimensionnée pour ne pas propager de modes parasites et/ou ne pas générer de résonances dans une bande de fréquences utiles du système.

12. Système selon l'une des revendications 10 ou 11 dans lequel lesdits tunnels sont configurés de manière à ce qu'une deuxième extrémité (Ext2) de chaque ligne ruban soit disposée sur un cercle présentant un diamètre supérieur au diamètre de la ligne coaxiale.

13. Système selon l'une des revendications 10 à 12 lequel chaque ligne ruban est configurée de manière à présenter à sa deuxième extrémité une impédance inférieure à l'impédance de sa première extrémité.

14. Systèmes selon l'une des revendications 10 à 13 comprenant en outre un absorbant (Abs) et/ou des couches résistives (CR) disposés dans la cavité entre les lignes ruban et/ou dans au moins une partie des tunnels.

15. Amplificateur hyperfréquence (100) comprenant :

   - un premier système (101) diviseur selon l'une des revendications 1 à 14 apte à transporter un signal hyperfréquence d'une première ligne coaxiale (CoaxI) vers une première pluralité de N lignes ruban (LRI),
   - une pluralité de N amplificateurs (A) dudit signal hyperfréquence couplés aux N premières lignes ruban,
   - un deuxième système (102) combineur selon l'une des revendications 1 à 14 présentant une deuxième pluralité de lignes ruban (LRII) couplées auxdits amplificateurs, apte à transporter le signal hyperfréquence amplifié des deuxièmes lignes ruban vers une deuxième ligne coaxiale (CoaxII).

**Patentansprüche**

1. Teiler-/Kombinationssystem für ein Hyperfrequenzsignal (10), Folgendes beinhaltend:

   - eine Koaxialleitung (Coax), beinhaltend einen inneren Block (Bint), welcher sich in Längsrichtung entlang einer Achse Y erstreckt, welche eine leitfähige Fläche aufweist und in einen äußeren Block (Bextl) eingefügt ist, welcher leitfähige innere Hohlraumwände aufweist, wobei der innere Block vom äußeren Block durch einen isolierenden Raum (E) getrennt ist, wobei die Koaxialleitung ein Anschlussende aufweist,
   - eine Vielzahl (LR) von N Streifenleitungen (LR1, LR2, ... LRN), wobei jede Streifenleitung einen ersten (BC1) und einen zweiten (BC2) leitfähigen Streifen beinhaltet, welche gegenüber beiderseits einem isolierenden oder dielektrischen Substrat (Sub) angeordnet sind,
   - eines der Enden einer jeden Streifenleitung, genannt erstes Ende (Ext1), tangential am Umfang des inneren Blocks (Bint) in dem Raum (E) am Anschlussende der Koaxialleitung (Coax) angeordnet ist, wobei der erste (BC1) und der zweite (BC2) leitfähige Streifen am ersten Ende (Ext1) der Streifenleitung jeweils in elektrischem Kontakt mit dem inneren Block (Bint) und dem äußeren Block (Bext1) steht, wobei der äußere Block zudem mit einer Masse des Systems verbunden ist,
   - der äußere Block (Bext1) sich in Längsrichtung entlang der Achse Y auf der gegenüberliegenden Seite des ersten Endes erstreckt, **dadurch gekennzeichnet, dass** die zweiten leitfähigen Streifen (BC2) stets in elektrischem Kontakt mit einer leitfähigen Innenwand der Verlängerung (Bext2) des äußeren Blocks stehen.

2. System nach Anspruch 1, bei welchem jedes erste Ende der Streifenleitungen eine Impedanz aufweist, welche an die Impedanz der Koaxialleitung am Anschlussende angepasst ist.

**3.** System nach Anspruch 2, bei welchem die Impedanz am ersten Ende (Ext1) einer jeden Streifenleitung im Wesentlichen gleich N Mal die Impedanz der Koaxialleitung (Coax) an deren Anschlussende beträgt, um so dazu beizutragen, die Impedanz eines jeden ersten Endes der Streifenleitungen an die Impedanz der Koaxialleitung an deren Anschlussende anzupassen.

**4.** System nach einem der Ansprüche 2 oder 3, bei welchem der innere Block und der äußere Block am Anschlussende Aussparungen (Evint, Evext) aufweisen, welche zwischen benachbarten Streifenleitungen befindlich sind, um so zur Impedanzanpassung beizutragen.

**5.** System nach einem der Ansprüche 2 bis 4, bei welchem für jede Streifenleitung die Breite (w), bei welcher die beiden leitfähigen Streifen (BC1, BC2) einander gegenüberliegen und ihre jeweiligen Dicken (l1, l2) so bestimmt sind, dass sie zur Impedanzanpassung beitragen.

**6.** System nach Anspruch 5, welches für ein Hyperfrequenzsignal im X-Band geeignet ist, bei welchem die Breite (w) kleiner oder gleich 1 mm ist und die Dicken (l1, l2) größer oder gleich 80 $\mu$m sind.

**7.** System nach einem der Ansprüche 2 bis 6, bei welchem die einander gegenüberliegenden leitfähigen Streifen seitlich in Bezug aufeinander am ersten Ende derart verschoben sind, dass sie zur Impedanzanpassung beitragen.

**8.** System nach einem der vorhergehenden Ansprüche, bei welchem der innere Block der Koaxialleitung eine konische Form aufweist.

**9.** System nach einem der vorhergehenden Ansprüche, bei welchem die Koaxialleitung als Monomode-Leitung in einem Nutzfrequenzband des Systems konfiguriert ist.

**10.** System nach einem der vorhergehenden Ansprüche, hergestellt in einem Block (B), beinhaltend den äußeren Block (Bext1), dessen Hohlrauminnenwände leitfähig sind, wobei das System zudem Folgendes beinhaltet:

- einen an das Anschlussende der Koaxialleitung angrenzenden Hohlraum (C), wobei die Streifenleitungen am Block befestigt sind, und
- eine Vielzahl von N Tunneln (T1, T2... TN), welche in den Block (B) gebohrt ist, wobei jeder Tunnel eine zugeordnete Streifenleitung beinhaltet.

**11.** System nach Anspruch 10, bei welchem der Hohlraum so dimensioniert ist, dass er keine Störmoden fortpflanzt und/oder keine Resonanz in einem Nutzfrequenzband des Systems erzeugt.

**12.** System nach einem der Ansprüche 10 oder 11, bei welchem die Tunnel so konfiguriert sind, dass ein zweites Ende (Ext2) einer jeden Streifenleitung an einem Kreis angeordnet ist, welcher einen größeren Durchmesser als den Durchmesser der Koaxialleitung aufweist.

**13.** System nach einem der Ansprüche 10 bis 12, bei welchem jede Streifenleitung so konfiguriert ist, dass sie an ihrem zweiten Ende eine kleinere Impedanz als die Impedanz ihres ersten Endes aufweist.

**14.** System nach einem der Ansprüche 10 bis 13, zudem beinhaltend ein Absorptionsmittel (Abs) und/oder Widerstandsschichten (CR), welche in dem Hohlraum zwischen den Streifenleitungen und/oder in mindestens einem Teil der Tunnel angeordnet sind.

**15.** Hyperfrequenzverstärker (100), Folgendes beinhaltend:

- ein erstes Teilersystem (101) nach einem der Ansprüche 1 bis 14, welches in der Lage ist, ein Hyperfrequenzsignal von einer ersten Koaxialleitung (CoaxI) zu einer ersten Vielzahl von N Streifenleitungen (LRI) zu transportieren,
- eine Vielzahl von N Verstärkern (A) des Hyperfrequenzsignals, gekoppelt mit den N ersten Streifenleitungen,
- ein zweites Kombinationssystem (102) nach einem der Ansprüche 1 bis 14, welches eine zweite Vielzahl von Streifenleitungen (LRII) aufweist, welche mit den Verstärken gekoppelt ist, welches in der Lage ist, das verstärkte Hyperfrequenzsignal von einer zweiten Streifenleitungen zu einer zweiten Koaxialleitung zu transportieren (CoaxII).

**Claims**

**1.** Splitter/combiner system for RF signals (10) comprising:

- a coaxial line (Coax) comprising an inner block (Bint) extending longitudinally along an axis Y, having a conductive surface and being inserted into an outer block (Bext1) whose inner cavities have conductive walls, the inner block being separated from the outer block by an insulating space (E), said coaxial line having a connection end;
- a plurality (LR) of N strip lines (LR1, LR2, ... LRN), each strip line comprising a first (BC1) and a second (BC2) conductive strip that are positioned facing either side of an insulating or dielectric substrate (Sub);

- one of the ends of each strip line, referred to as the first end (Ext1), being positioned tangentially on the rim of the inner block (Bint) in said space (E) at the connection end of the coaxial line (Coax), the first (BC1) and the second (BC2) conductive strips of the first end (Ext1) of the strip line respectively being in electrical contact with the inner block (Bint) and the outer block (Bext1), the outer block additionally being connected to the system ground,

- the outer block (Bext1) extending longitudinally along the axis Y on the opposite side of the first end, **characterized in that** said second conductive strips (BC2) are always in electrical contact with a conductive inner wall of said extension (Bext2) of said outer block.

2. System according to Claim 1, in which the impedance of each first end of the strip lines is matched to the impedance of the coaxial line at the connection end.

3. System according to Claim 2, in which an impedance at the first end (Ext1) of each strip line is substantially equal to N times the impedance of the coaxial line (Coax) at its connection end, so as to contribute to matching the impedance of each first end of the strip lines to the impedance of the coaxial line at its connection end.

4. System according to one of Claims 2 or 3, in which the inner block and the outer block have, at the connection end, voids (Evint, Evext) that are located between adjacent strip lines, so as to contribute to said impedance matching.

5. System according to one of Claims 2 to 4, in which, for each strip line, the width (w) over which the two conductive strips (BC1, BC2) are facing one another, along with their respective thicknesses (l1, l2), are determined so as to contribute to said impedance matching.

6. System according to Claim 5, suitable for an X-band RF signal, in which said width (w) is smaller than or equal to 1 mm and said thicknesses (l1,l2) are greater than or equal to 80 $\mu$m.

7. System according to one of Claims 2 to 6, in which the facing conductive strips are laterally offset with respect to one another at the first end so as to contribute to said impedance matching.

8. System according to one of the preceding claims, in which the form of the inner block of the coaxial line is conical.

9. System according to one of the preceding claims, in which the coaxial line is configured so as to be single mode in a useful frequency band of the system.

10. System according to one of the preceding claims, produced in a block (B) comprising the outer block (Bext1) and whose inner cavities have conductive walls, said system additionally comprising:

    - a cavity (C) adjoining the connection end of the coaxial line, the strip lines being fixed to the block, and
    - a plurality of N tunnels (T1, T2... TN) hollowed out of said block (B), each tunnel comprising an associated strip line.

11. System according to Claim 10, in which said cavity is dimensioned so as not to propagate parasitic modes and/or not to generate resonances in a useful band of frequencies of the system.

12. System according to one of Claims 10 or 11, in which said tunnels are configured so that a second end (Ext2) of each strip line is positioned in a circle having a diameter that is greater than the diameter of the coaxial line.

13. System according to one of Claims 10 to 12, in which each strip line is configured so that the impedance at its second end is lower than the impedance at its first end.

14. Systems according to one of Claims 10 to 13, additionally comprising an absorbent (Abs) and/or resistive layers (CR) that are positioned in the cavity between the strip lines and/or in at least a portion of the tunnels.

15. RF amplifier (100) comprising:

    - a first splitter system (101) according to one of Claims 1 to 14, capable of conveying an RF signal from a first coaxial line (CoaxI) to a first plurality of N strip lines (LRI);
    - a plurality of N amplifiers (A) of said RF signal that are coupled to the N first strip lines;
    - a second combiner system (102) according to one of Claims 1 to 14, having a second plurality of strip lines (LRII) that are coupled to said amplifiers, which is capable of conveying the amplified RF signal from the second strip lines to a second coaxial line (CoaxII).

FIG.1

FIG.2

FIG.3

FIG.4

FIG.5

FIG.6

FIG.7

FIG.8

FIG.9

C-C

Bext2

C

$T_i$

$LR_i$

FIG.10

Bext2

$T_i$

$LR_i$

FIG.11

FIG.12

Ext1

Ext2

## FIG.13

Ext1

Ext2

## FIG.14a

## FIG.14b

## FIG.14c

FIG.15

FIG.16

FIG.17

EP 3 136 499 B1

**EP 3 136 499 B1**

## RÉFÉRENCES CITÉES DANS LA DESCRIPTION

**Documents brevets cités dans la description**

- US 5142253 A
- US 2014016788 A
- CN 102280681
- US 5256988 A